# EUROPEAN PATENT APPLICATION

(11) **EP 4 760 320 A1**
(43) Date of publication of application: **17.06.2026**
(21) Application number: 25222300.3
(22) Date of filing: 10.12.2025
(51) Int. Cl.: G01R 31/54, B60L 58/18, G01R 31/66, H01M 10/42, H01M 10/48, H04Q 9/00, G01R 31/396

(54) **SYSTEM AND METHOD OF DETECTING MODULE BMS MISCONNECTION**

(30) Priority: 13.12.2024 KR 20240186535
(71) Applicant: SAMSUNG SDI CO., LTD., Yongin-si, Gyeonggi-do 17084 (KR)
(72) Inventor: SIM, Sangbong, 17084 Yongin-si (KR)
(74) Representative: Maiwald GmbH

(57) **Abstract**

Provided are a system and a method of detecting a module battery management system (BMS) misconnection. A system for detecting a BMS misconnection includes an input interface device (1350) configured to receive a response based on a result of an attempt of communication with a plurality of module BMSs, a memory (1330) configured to store a program that analyzes the response and detects whether a module BMS misconnection is present, and a processor (1310) configured to execute the program. The processor determines wire connection types of the plurality of module BMSs, and detects whether the module BMS misconnection is present.

## Description

### FIELD

The present disclosure relates to a system and a method of detecting a module battery management system (BMS) misconnection.

### BACKGROUND

As a rack structure has changed from a vertical type to a horizontal type, the same type of connector has been applied to both the input and output communication connectors of a module battery management system (BMS). Accordingly, a problem arises in that hardware fool-proofing cannot be ensured during communication wire connection.

### SUMMARY

The present disclosure is directed to providing a system and a method of detecting a module battery management system (BMS) misconnection by designing the system so that the detection of a module BMS misconnection can be replaced with software-based detection.

A system for detecting a module battery management system (BMS) misconnection according to the present disclosure may include an input interface device configured to receive a response based on a result of an attempt of communication with a plurality of module BMSs, a memory configured to store a program that analyzes the response and detects whether a module BMS misconnection is present, and a processor configured to execute the program. The processor may determine wire connection types of the plurality of module BMSs, and detect whether a module BMS misconnection is present.

The communication may be inter-integrated circuit (I2C) communication, and may be attempted with each of an upper communication integrated circuit (IC) and a lower communication IC included in each of the module BMSs.

The upper communication IC may include an upper analog front end (AFE) IC, and the lower communication IC may include a lower AFE IC.

The processor may be configured to analyze whether the response is received from a read-only memory (ROM) IC connected to the lower AFE IC, and determine a wire connection type of each of the module BMSs.

The ROM IC may include an electrically erasable programmable read-only memory (EEPROM) IC.

In the case where the response is received from the AFE IC of a first preset order, the processor may determine that the wire connection type of the module BMS is a left type.

In the case where the response is received from the AFE IC of a second preset order, the processor may determine that the wire connection type of the module BMS is a right type.

The processor may determine the wire connection types of the plurality of module BMSs, and may transmit position and misconnection detection information of a detected module BMS corresponding to a wire connection type different from a wire connection type of remaining module BMSs.

A method of detecting a module battery management system (BMS) misconnection according to the present disclosure may include an operation (a) of attempting communication with a plurality of module BMSs, and checking whether a response is received for each communication attempt, an operation (b) of checking whether a response is received from a communication integrated circuit (IC) of a preset order, and determining a wire connection state of each module BMS, and an operation (c) of detecting whether a misconnection is present among the plurality of module BMS.

The operation (a) may include attempting inter-integrated circuit (I2C) communication with each of a lower analog front end (AFE) IC and an upper analog front end (AFE) IC included in each of the plurality of module MBMSs
The operation (b) may include determining that the wire connection state is a left type, in a case where a response is received from an AFE IC of a first preset order.

The operation (b) may include determining that the wire connection state is a right type, in a case where a response is received from an AFE IC of a second preset order.

The operation (c) may include checking the wire connection state up to a final module BMS, determining that no misconnection is present in a case where all of the module BMSs are determined to have an identical wire connection state, and, in a case where a module BMS having a wire connection state different from a wire connection state of remaining module BMSs is detected, transmitting position and misconnection detection information of the corresponding module BMS to request inspection.

### EFFECT OF THE INVENTION

According to the present disclosure, an effect may be achieved in that a foolproof design can be implemented by checking a wire connection state of communication wires and detecting a misconnection in module battery management systems (BMSs) connected in a daisy chain.

Effects of the present disclosure are not limited to the aforementioned effects, and the other effects not described herein may be evidently understood by those skilled in the art.

### BRIEF DESCRIPTION OF THE DRAWINGS

The following drawings illustrate example embodiments of the present disclosure, and further describe example aspects of the present disclosure together with the detailed description of the present disclosure. Thus, the present disclosure should not be construed as being limited to the drawings:
FIG. 1 schematically illustrates an electrode assembly of a secondary battery;
FIG. 2 schematically illustrates a configuration of a pouch-type secondary battery;
FIG. 3 illustrates a schematic external appearance configuration of a prismatic secondary battery;
FIG. 4 is a cross-sectional view of a cylindrical secondary battery;
FIG. 5 illustrates a left-type wire connection state according to embodiments of the present disclosure.
FIG. 6 illustrates a right-type wire connection state according to embodiments of the present disclosure.
FIG. 7 illustrates a situation in which a misconnection occurs in the left-type wire connection according to embodiments of the present disclosure.
FIG. 8 illustrates a method of detecting a module battery management system (BMS) misconnection according to embodiments of the present disclosure.
FIG. 9 is a block diagram illustrating a computer system for implementing the method according to embodiments of the present disclosure.
FIG. 10 is an example view of a secondary battery module in which secondary batteries manufactured according to examples of the present disclosure are arranged.
FIG. 11 is an example view of a secondary battery pack including the secondary battery module illustrated in FIG. 21; and
FIG. 12 is a conceptual view of a vehicle including the secondary battery pack illustrated in FIG. 11.

### DETAILED DESCRIPTION OF EXEMPLARY EMBODIMENTS

Hereinafter, example embodiments of the present disclosure will be described, in detail, with reference to the accompanying drawings. The terms or words used in the present specification and claims are not to be limitedly interpreted based on their general or ordinary meaning, and should be interpreted as meanings and concepts that are consistent with the technical idea of the present disclosure on the basis of the principle that an inventor can be their own lexicographer to appropriately define concepts of terms to describe their disclosure in the best way.

The example embodiments described in this specification and the configurations shown in the drawings are only some example embodiments of the present disclosure and do not represent all of the aspects of the present disclosure. Accordingly, it should be understood that there may be various equivalents and modifications that can replace or modify one or more example embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above" "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges is within the scope of this disclosure.

References to two compared elements, features, etc. As being "the same" may mean that they are "substantially the same." Thus, the phrase "substantially the same" may include a circumstance having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

The terminology used herein is for the purpose of describing example embodiments of the present disclosure and is not intended to limit the present disclosure.

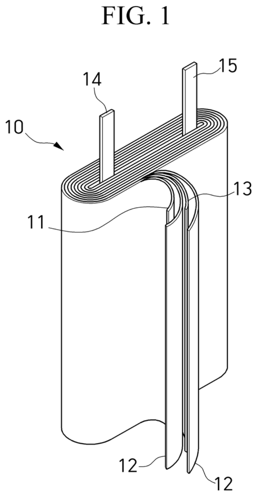

FIG. 1 schematically illustrates an electrode assembly built in a case of a secondary battery.

An electrode assembly 10 may be formed by winding or stacking a stack of a first electrode plate 11, a separator 12, and a second electrode plate 13, which are formed as thin plates or films. When the electrode assembly 10 is a wound stack, a winding axis may be parallel to the longitudinal direction (e.g., the y direction) of the case. In other example embodiments, the electrode assembly 10 may be a stack type rather than a winding type, and the shape of the electrode assembly 10 is not limited in the examples of the present disclosure. In addition, the electrode assembly 10 may be or include a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the examples of the present disclosure. The first electrode plate 11 of the electrode assembly may act as a negative electrode, and the second electrode plate 13 may act as a positive electrode. In examples, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some example embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than, e.g., farther than or beyond, the separator 12 without being separately cut.

The second electrode plate 13 may be formed by applying a second electrode active material, such as a transition metal oxide, on a second electrode current collector formed of or including a metal foil, such as aluminum or an aluminum alloy. The second electrode plate 13 may include a second electrode tab 15 (e.g., a second uncoated portion) that is or includes a region to which the second electrode active material is not applied. The second electrode tab 15 may be connected to an external second terminal (not shown). In some example embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than, e.g., farther than or beyond, the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 hinders or substantially prevents a short-circuit between the first electrode 11 and the second electrode 13 while allowing movement of lithium ions therebetween. The separator 12 may be made of or include, for example, a polyethylene film, a polypropylene film, a polyethylene-polypropylene film, etc.

In some example embodiments, the electrode assembly 10 may be accommodated in the case (not shown) along with an electrolyte. In the circumstance of a pouch-type secondary battery, an electrode assembly 10 may be accommodated in a pouch made of or including flexible material in the form illustrated in FIG. 1. In the circumstance of a prismatic secondary battery, an electrode assembly 10 may be accommodated in a prismatic metal casing in the form illustrated in FIG. 1.

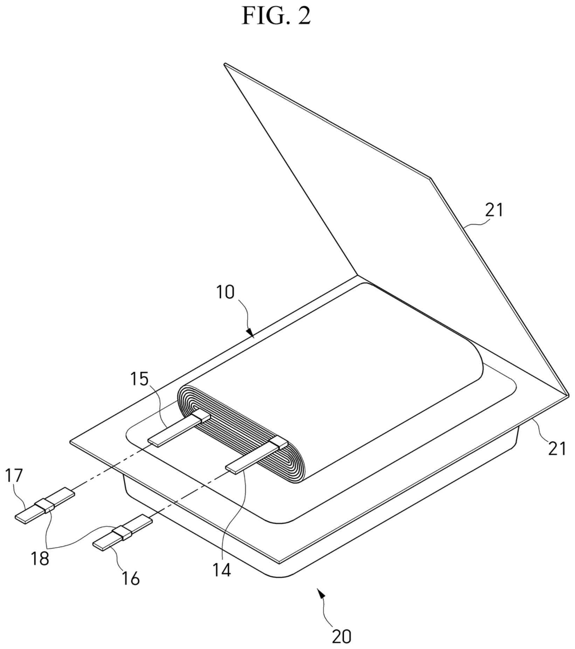

FIG. 2 schematically illustrates the pouch-type secondary battery.

The pouch-type secondary battery includes an electrode assembly 10 and a pouch 20 that accommodates or contains the electrode assembly 10 therein.

The electrode assembly 10 may be the same as the electrode assembly 10 illustrated in FIG. 1. The first electrode tab 14 and the second electrode tab 15 of the electrode assembly 10 may be electrically connected to respective external first and second terminal leads 16 and 17 by ,e.g., welding or other attaching method that preserves conductivity therebetween. At least a portion of each of the first terminal lead 16 and the second terminal lead 17 may be attached or covered with a tab film 18 for insulation from the pouch 20.

The pouch 20 may be sealed by having sealing parts 21 at the edges thereof come into contact with each other while accommodating or containing the electrode assembly 10 therein, in which circumstance the sealing may be achieved with the tab film 18 interposed between the sealing parts 21. The sealing parts 21 of the pouch 20 may be made of or include a thermal fusion material that generally has weak adhesion to metal. Thus, it may be fused to the pouch 20 by interposing the thin tab film 18 between the sealing parts 21.

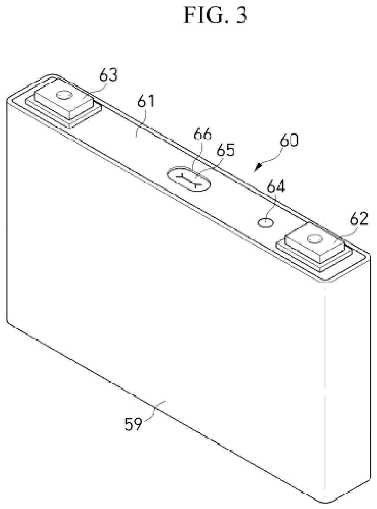

FIG. 3 illustrates a schematic external appearance configuration of a prismatic secondary battery.

A prismatic case 59 defines an overall appearance of the prismatic secondary battery, and may be made of or include a conductive metal, such as aluminum, aluminum alloy, or nickel-plated steel. In addition, the case 59 may provide a space for accommodating or containing the electrode assembly 10 therein.

A cap assembly 60 may include a cap plate 61 that covers an opening of the case 59, and the case 59 and the cap plate 61 may be made of or include a conductive material. A first terminal 63 and a second terminal 62 may be electrically connected to the first electrode tab 14 and the second electrode tab 15 of the electrode assembly 10 illustrated in FIGS. 1 and 2 inside the case 59, and may be installed to protrude outward through the cap plate 61.

The cap plate 61 may be equipped with or include an electrolyte injection port 64 configured to install a sealing plug therein, and a vent 66 formed that includes a notch 65 may be installed. The vent 66 is configured to discharge any gas generated inside the secondary battery.

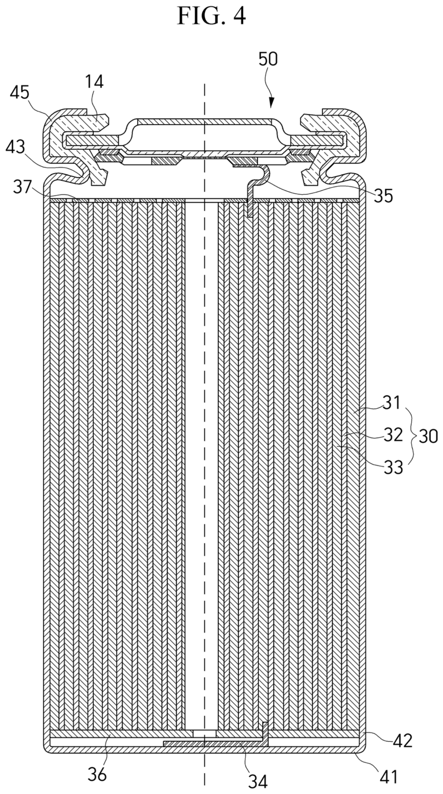

FIG. 4 is a cross-sectional view of a cylindrical secondary battery.

The cylindrical secondary battery includes an electrode assembly 30, a case accommodating the electrode assembly 30 and an electrolyte therein, a cap assembly 50 coupled to an opening of the case to seal the case, and an insulating plate 37 located between the electrode assembly 30 and the cap assembly 50 inside the case.

The electrode assembly 30 may include a separator 32 between a first electrode 33 and a second electrode 31, and the electrode assembly 30 may be wound in a jelly-roll form.

The first electrode 33 may include a first substrate and a first active material layer located on the first substrate. A first lead tab 35 may extend outward from a first uncoated portion of the first substrate where the first active material layer is not located, and may be electrically connected to the cap assembly 50.

The second electrode 31 may include a second substrate and a second active material layer located on the second substrate. A second lead tab 34 may extend outward from a second uncoated portion of the second substrate where the second active material layer is not located, and may be electrically connected to the case. The first lead tab 35 and the second lead tab 34 may extend in opposite directions with respect to each other.

The first electrode 33 may constitute a positive electrode. In this circumstance, the first substrate may be composed of or include, for example, aluminum foil, and the first active material layer may include, for example, a transition metal oxide. The second electrode 31 may constitute a negative electrode. In this case, the second substrate may be composed of or include, for example, copper foil or nickel foil, and the second active material layer may include, for example, graphite.

The separator 32 may reduce or prevent a short-circuit between the first electrode 33 and the second electrode 31 while allowing movement of lithium ions therebetween. The separator 32 may be made of or include, for example, at least one of a polyethylene film, a polypropylene film, a polyethylene-polypropylene film, etc.

The case accommodates or contains the electrode assembly 30 and the electrolyte, and substantially forms the external appearance of the secondary battery together with the cap assembly 50. The case may have a substantially cylindrical body portion 42, and a bottom portion 41 connected to one side of the body portion 42. A beading part 43 deformed inwardly may be formed in the body portion 42, and a crimping part 45 bent inwardly may be formed at an open end of the body portion 42.

The beading part 43 may reduce or prevent movement of the electrode assembly 30 inside the case, and may facilitate seating of a gasket 44 and the cap assembly 50. A crimping part 45 may firmly fix the cap assembly 50 by pressing the edge of the cap assembly 50 against the gasket 44. The case may be formed of or include iron plated with nickel, for example.

The cap assembly 50 may be fixed to the inside of the crimping part 45 through the gasket 44 to seal the case. The cap assembly 50 may include a cap up, a safety vent, a cap down, an insulating member, and a subplate, but is not limited to this example and may be variously modified.

The cap up may be located at the very top of the cap assembly 50. The cap up may include a terminal portion that protrudes convexly upward and is connected to an external circuit, and an outlet for discharging gas may be located around the terminal portion.

The safety vent may be located below the cap up. The safety vent may include a protrusion that protrudes convexly downward and is connected to the subplate, and at least one notch located around the protrusion.

When gas is generated due to overcharging or abnormal operation of the secondary battery, the protrusion may be deformed upward by pressure and may separate from the subplate, while the safety vent may be cut along the notch. The cut safety vent may hinder or prevent the secondary battery from exploding by discharging gas to the outside.

The cap down may be located below the safety vent. The cap down may be formed with a first opening for exposing the protrusion of the safety vent and a second opening for discharging gas. The insulating member may be located between the safety vent and the cap down to insulate the safety vent and the cap down.

The subplate may be located below the cap down. The subplate may be fixed to a lower surface of the cap down to block the first opening of the cap down, and the protrusion of the safety vent may be fixed to the subplate. The first lead tab 35 pulled out from the electrode assembly 30 may be fixed to the subplate. Accordingly, the cap up, the safety vent, the cap down, and the subplate may be electrically connected to the first electrode 33 of the electrode assembly 30.

The insulating plate 37 may be located below the beading part 43 to be in contact with the electrode assembly 30, and may be provided with a tab opening for pulling out the first lead tab 35. The cap assembly 50, which is electrically connected to the first electrode 33 by the first lead tab 35, may face the electrode assembly 30 with the insulating plate 37 interposed therebetween, and may maintain an insulated state from the electrode assembly 30 by the insulating plate 37. On the other hand, another insulating plate 36 may be included for insulation between the electrode assembly 30 and the bottom portion 41 of the case.

Hereinafter, the background of the present disclosure will be described to aid understanding by those skilled in the art, followed by descriptions of embodiments of the present disclosure.

In a power module battery management system (BMS), two analog front end (AFE) integrated circuits (ICs) may be mounted, including an upper AFE and a lower AFE.

In the case where a plurality of module BMSs are connected using communication wires, a signal may be transmitted through a daisy-chain configuration (a configuration in which hardware devices are connected sequentially) during booting, thus aligning the order of the AFEs.

A read-only memory (ROM) integrated circuit (IC) may be applied to the lower AFE, and a printed board assembly (PBA) barcode of the module BMS and a serial number of the module may be recorded in the ROM. The recorded information may be utilized for managing the maintenance history of each module.

As a rack structure changes from a vertical type to a horizontal type, the same type of connector may be applied to both the input and output communication connectors of the module BMS. Accordingly, a problem may arise in that hardware fool-proofing cannot be ensured when connecting communication wires.

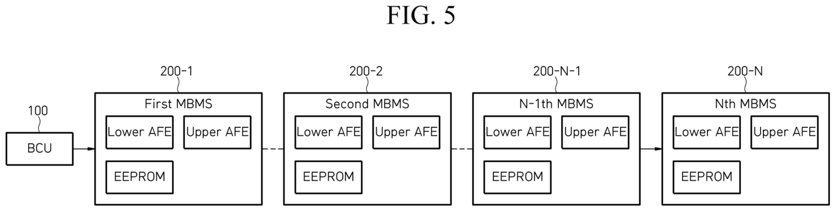

The present disclosure has been proposed to address the above-described problem, and proposes a system and a method for detecting a module BMS misconnection, which are designed to enable detection of a module BMS misconnection through software-based implementation. Hereinafter, embodiments of the present disclosure will be described with reference to FIGS. 5 to 8.

A plurality of module battery management systems MBMSs may be arranged, and a first MBMS 200-1, a second MBMS 200-2, ... an (N-1)th MBMS 200-N-1, and an Nth MBMS 200-N may be arranged and connected to a battery control unit (BCU) 100.

A lower AFC and an upper AFE may be mounted in each MBMS, and a ROM IC {electrically erasable programmable read-only memory (EEPROM) IC} may be connected to the lower AFE.

Upon power-up, a communication state with the ROM IC (EEPROM IC) may be checked for each MBMS to confirm a wire connection state.

The BCU 100 may attempt communication (I2C communication) with each of the lower AFE and the upper AFE of the first MBMS 200-1 to check whether the ROM IC (EEPROM IC) responds via I2C.

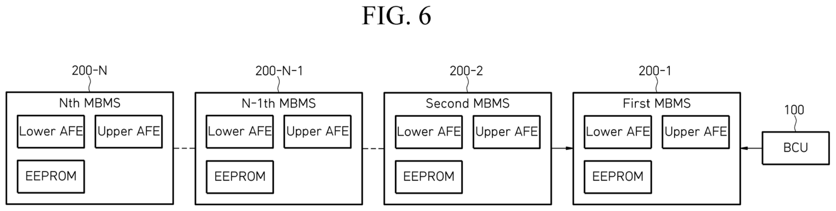

FIG. 5 illustrates a left-type wire connection state according to embodiments of the present disclosure, and FIG. 6 illustrates a right-type wire connection state according to embodiments of the present disclosure.

In the case where a response from the ROM IC (EEPROM IC) is received from an AFE of a first preset order (e.g., 1, 3, 5, 7, 9, ...) based on the BCU 100, the wire connection state may be determined to be a left type.

In the case where a response from the ROM IC (EEPROM IC) is received from an AFE of a second preset order, which is different from the first preset order, based on the BCU 100 (e.g., 2, 4, 6, 8, 10, ...), the wire connection state may be determined to be a right type.

The above-described process may be performed up to the last MBMS, that is, the Nth MBMS 200-N, to check the wire connection state, and whether there is an MBMS having a different wire connection state may be determined.

In the case where the wire connection states of all MBMSs are the same, the wire connection structure of the current rack may be determined to be either a left type or a right type.

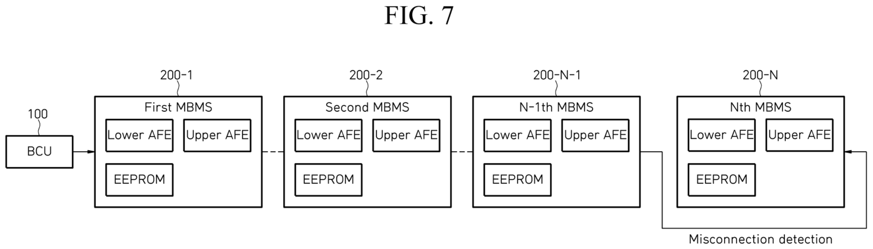

FIG. 7 illustrates a situation in which a misconnection occurs in the left-type wire connection according to embodiments of the present disclosure.

In the case where any one of the plurality of MBMSs is determined to have a wire connection state different from the others, misconnection information and a position of the corresponding MBMS may be transmitted to assist in performing inspection.

According to embodiments of the present disclosure, in the case where a response is received from an AFC of an order different from a preset AFE order, a misconnection may be detected.

According to embodiments of the present disclosure, in the case where the ROM IC (EEPROM IC) is disposed in the upper AFE instead of the lower AFE and a response from the ROM IC (EEPROM IC) is received, that is, in the case where responses are successively received not as odd-numbered or even-numbered responses, the case may be determined to be an error in producing the MBMSs rather than a misconnection.

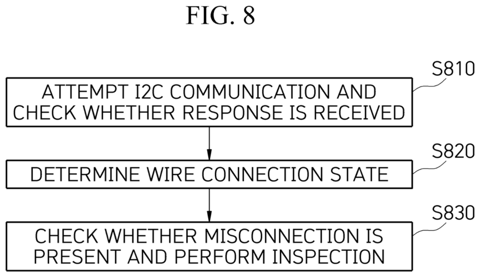

FIG. 8 illustrates a method of detecting a module BMS misconnection according to embodiments of the present disclosure.

At step S810, communication (I2C communication) may be attempted with the plurality of MBMSs, and whether a response is received for the communication attempt may be checked.

At step S810, the I2C communication may be attempted with the lower AFE and the upper AFE included in each of the plurality of MBMSs.

At step S820, in the case where a response is received from an AFE of a first preset order, the wire connection state may be determined to be a left type. For example, when a response is received from an AFE of an odd-numbered order, the wire connection with the corresponding MBMS may be determined to be a left type.

At step S820, in the case where a response is received from an AFE of a second preset order different from the first preset order, the wire connection state may be determined to be a left type. For example, when a response is received from an AFE of an even-numbered order, the wire connection with the corresponding MBMS may be determined to be a right type.

At step S830, the wire connection state may be checked up to a final MBMS (i.e., the last MBMS among the arranged MBMSs), and in the case where all are checked to have the same wire connection state, the wire connection state may be finally determined.

At step S830, in the case where an MBMS having a wire connection state different from that of other MBMSs is detected among the plurality of MBMSs, misconnection information and the position of the corresponding MBMS are transmitted so that inspection may be performed.

At step S830, in the case where the ROM IC (EEPROM IC) is disposed in the upper AFE instead of the lower AFE, unlike a preset design (in which the EEPROM is connected to the lower AFE), and a response from the ROM IC (EEPROM IC) is received, that is, in the case where responses are successively received rather than being received as odd-numbered or even-numbered responses, the case may be determined to be an error in producing the MBMSs rather than a misconnection.

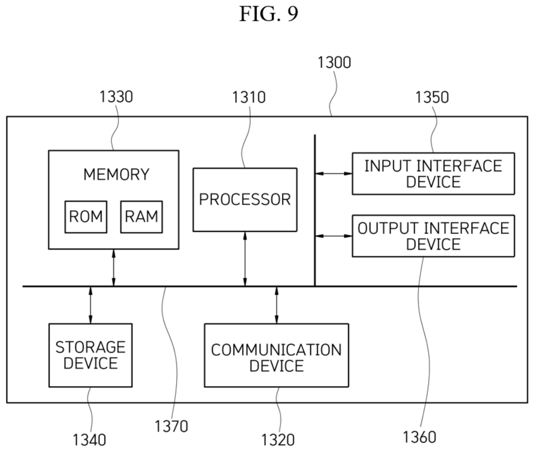

FIG. 9 is a block diagram illustrating a computer system for implementing the method according to embodiments of the present disclosure.

Referring to FIG. 9, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

A system for detecting a module BMS misconnection according to embodiments of the present disclosure may include an input interface device 1350 configured to receive a response based on a result of a communication attempt with a module BMS, a memory 1330 in which a program for analyzing the response and detecting whether a module BMS misconnection has occurred is stored, and a processor 1310 configured to execute the program. The processor 1310 may determine a wire connection type of a plurality of module BMSs and detect whether a misconnection has occurred.

Communication may be attempted with each of the upper AFE IC and the lower AFE IC included in the module BMS.

The processor 1310 may analyze whether a response has been received from the ROM IC (EEPROM IC) connected to the lower AFE IC, and determine a wire connection type of the module BMS.

In the case where a response is received from an AFE IC of a first preset order, the processor 1310 may determine that the wire connection type of the module BMS is a left type.

In the case where a response is received from an AFE IC of a second preset order, the processor 1310 may determine that the wire connection type of the module BMS is a right type.

The processor 1310 may determine wire connection types of the plurality of module BMSs, and transmit the position and misconnection detection information of a detected module BMS corresponding to a wire connection type different from those of the other module BMSs.

In the case where responses are received successively rather than in a preset order (i.e., as odd-numbered or even-numbered responses), the processor 1310 may determine that the case corresponds to an error in producing the MBMSs rather than a misconnection.

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magneto-optical media such as floptical disks, ROM, RAM, flash memory, etc. The program instructions may include not only machine language codes such as that generated by a compiler, but also high-level language codes that can be executed by a computer through an interpreter, etc.

Hereinafter, any material that may be usable for the secondary battery according to examples of the present disclosure will be described.

As the positive electrode active material, a compound capable of reversibly intercalating/deintercalating lithium (e.g., a lithiated intercalation compound) may be used. For example, at least one of a composite oxide of lithium and a metal such as at least one of cobalt, manganese, nickel, and combinations thereof may be used.

The composite oxide may be or include a lithium transition metal composite oxide, and examples thereof may include at least one of a lithium nickel-based oxide, a lithium cobalt-based oxide, a lithium manganese-based oxide, a lithium iron phosphate-based compound, a cobalt-free nickel-manganese-based oxide, or a combination thereof.

As an example, a compound represented by at least any one of the following formulas may be used: LiaA1-bXbO2-cDc (0.90 ≤ a ≤ 1.8, 0 ≤ b ≤ 0.5, 0 ≤ c ≤ 0.05); LiaMn2-bXbO4-cDc (0.90≤a≤1.8, 0≤b≤0.5, 0≤c≤0.05); LiaNi1-b-cCobXcO2-αD α (0.90≤a≤1.8, 0≤b≤0.5, 0≤c≤0.5, 0<α<2); LiaNi1-b-cMnbXcO2-αDα (0.90≤a ≤1.8, 0≤b≤0.5, 0≤c≤0.5, 0<α<2); LiaNibCocL1dGeO2 (0.90≤a≤1.8, 0≤b≤0.9, 0 ≤ c ≤ 0.5, 0 ≤ d ≤ 0.5, 0 ≤ e ≤ 0.1); LiaNiGbO2 (0.90 ≤ a ≤ 1.8, 0.001 ≤ b ≤ 0.1); LiaCoGbO2 (0.90≤a≤1.8, 0.001≤b≤0.1); LiaMn1-bGbO2 (0.90≤a≤1.8, 0.001≤b ≤0.1); LiaMn2GbO4 (0.90≤a≤1.8, 0.001≤b≤0.1); LiaMn1-gGgPO4 (0.90≤a≤1.8, 0≤g≤0.5); Li(3-f)Fe2(PO4)3 (0≤f≤2); and LiaFePO4 (0.90≤a≤1.8).

In the above formulas: A is or includes at least Ni, Co, Mn, or a combination thereof; X is or includes at least Al, Ni, Co, Mn, Cr, Fe, Mg, Sr, V, a rare earth element, or a combination thereof; D is or includes at least O, F, S, P, or a combination thereof; G is or includes at least Al, Cr, Mn, Fe, Mg, La, Ce, Sr, V, or a combination thereof; and L1 is or includes at least Mn, Al, or a combination thereof.

A positive electrode for a lithium secondary battery may include a current collector and a positive electrode active material layer formed on the current collector. The positive electrode active material layer may include a positive electrode active material and may further include a binder and/or a conductive material.

The content of the positive electrode active material is in a range of about 90 wt% to about 99.5 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The current collector may be or include aluminum (Al) but is not limited thereto.

The negative electrode active material may include a material capable of reversibly intercalating/deintercalating at least one of lithium ions, lithium metal, an alloy of lithium metal, a material capable of being doped and undoped with lithium, or a transition metal oxide.

The material capable of reversibly intercalating/deintercalating lithium ions may be or include a carbon-based negative electrode active material, which may include, for example, at least crystalline carbon, amorphous carbon, or a combination thereof. Examples of the crystalline carbon may include graphite, such as natural graphite or artificial graphite, and examples of the amorphous carbon may include at least one of soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be or include at least silicon, a silicon-carbon composite, SiOx (0 < x < 2), a Si-based alloy, or a combination thereof.

The silicon-carbon composite may be or include a composite of silicon and amorphous carbon. According to one example embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a current collector and a negative electrode active material layer disposed on the current collector. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and about 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting viscosity may be further included.

As the negative electrode current collector, at least one of copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent may constitute a medium through which ions involved in the electrochemical reaction of the battery can move.

The non-aqueous organic solvent may be or include at least a carbonate-based, an ester-based, an ether-based, a ketone-based, an alcohol-based solvent, an aprotic solvent, and may be used alone or in combination of two or more.

Depending on the type of lithium secondary battery, a separator may be present between the first electrode plate (e.g., the negative electrode) and the second electrode plate (e.g., the positive electrode). As the separator, at least polyethylene, polypropylene, polyvinylidene fluoride, or a multilayer film of two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles such as at least one of Al2O3, SiO2, TiO2, SnO2, CeO2, MgO, NiO, CaO, GaO, ZnO, ZrO2, Y2O3, SrTiO3, BaTiO3, Mg(OH)2, boehmite, and combinations thereof but is not limited thereto.

The organic material and the inorganic material may be mixed in one coating layer or may be in the form of a coating layer containing an organic material and a coating layer containing an inorganic material that are laminated on each other.

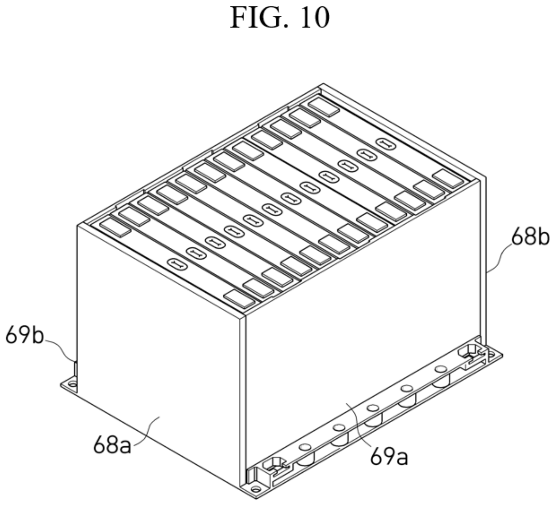

FIG. 10 is an illustration of a secondary battery module in which secondary batteries manufactured according to examples of the present disclosure are arranged. With the increase in secondary battery capacity for driving electric vehicles, and the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in arrangement (direction) and number to obtain desired voltage and current specifications.

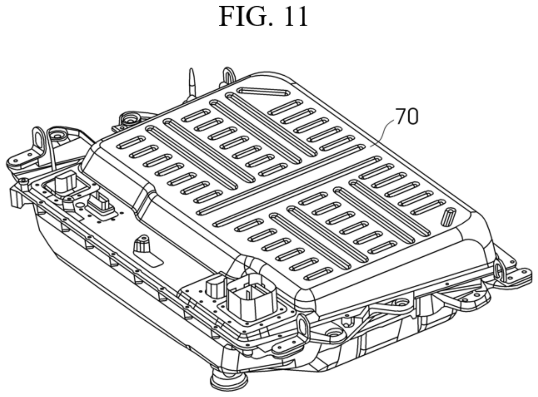

FIG. 11 is an illustration schematically showing the configuration of a battery pack 70 according to example embodiments of the present disclosure. Referring to FIG. 11, a battery pack 70 may include an assembly to which individual batteries are electrically connected, and a pack housing accommodating the same. In the drawings, for convenience of illustration, components including a bus bar, a cooling unit, external terminals for electrically connecting batteries, etc., are not shown.

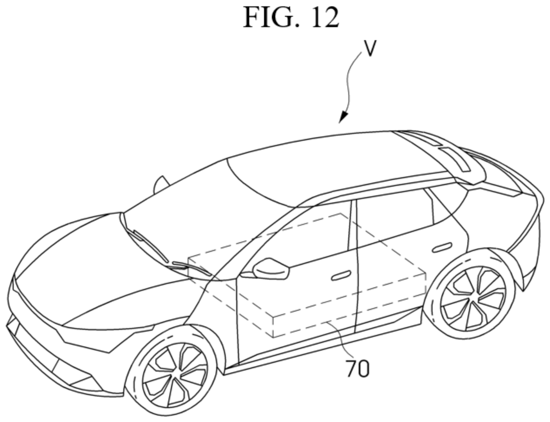

The battery pack 70 may be mounted on (or in) a vehicle. The vehicle may be, for example, an electric vehicle, a hybrid vehicle, a plug-in hybrid vehicle, and the like. The vehicle may be a four-wheeled vehicle or a two-wheeled vehicle but is not limited thereto. FIG. 12 shows a vehicle V which includes the battery pack 70 shown in FIG. 11 on the lower body thereof. The vehicle V may operate by (e.g., may be powered by) receiving power from the battery pack 70.

Although the present disclosure has been described herein with respect to example embodiments thereof, the present disclosure is not limited thereto. Various modifications and variations can be made thereto by those skilled in the art within the spirit of the present disclosure and the equivalent scope of the appended claims.

## Claims

1. A system for detecting a module battery management system, BMS, misconnection comprising:
an input interface device configured to receive a response based on a result of an attempt of communication with a plurality of module BMSs;
a memory configured to store a program that analyzes the response and detects whether a module BMS misconnection is present; and
a processor configured to execute the program,
wherein the processor determines wire connection types of the plurality of module BMSs, and detects whether a module BMS misconnection is present.

2. The system as claimed in claim 1, wherein the communication is inter-integrated circuit, I2C, communication, and is attempted with each of an upper communication integrated circuit, IC, and a lower communication IC included in each of the module BMSs.

3. The system as claimed in claim 2, wherein the upper communication IC comprises an upper analog front end, AFE, IC, and the lower communication IC comprises a lower AFE IC.

4. The system as claimed in claim 3, wherein the processor is configured to analyze whether the response is received from a read-only memory, ROM, IC connected to the lower AFE IC, and determine a wire connection type of each of the module BMSs.

5. The system as claimed in claim 4, wherein the ROM IC comprises an electrically erasable programmable read-only memory, EEPROM, IC.

6. The system as claimed in claim 4 or 5, wherein in a case where the response is received from the AFE IC of a first preset order, the processor determines that the wire connection type of the module BMS is a left type.

7. The system as claimed in claim 6, wherein in a case where the response is received from the AFE IC of a second preset order, the processor determines that the wire connection type of the module BMS is a right type.

8. The system as claimed in any one of the preceding claims, wherein the processor determines the wire connection types of the plurality of module BMSs, and transmits position and misconnection detection information of a detected module BMS corresponding to a wire connection type different from a wire connection type of remaining module BMSs.

9. A method of detecting a module battery management system, (BMS, misconnection using a system for detecting a module BMS misconnection, the method comprising:
an operation (a) of attempting (S810) communication with a plurality of module BMSs, and checking (S820) whether a response is received for each communication attempt;
an operation (b) of checking (S830) whether a response is received from a communication integrated circuit, IC, of a preset order, and determining a wire connection state of each module BMS; and
an operation (c) of detecting whether a misconnection is present among the plurality of module BMS.

10. The method as claimed in claim 9, wherein the operation (a) comprises attempting inter-integrated circuit, I2C, communication with each of a lower analog front end, AFE, IC and an upper analog front end, AFE, IC included in each of the plurality of module MBMSs.

11. The method as claimed in claim 9 or 10, wherein the operation (b) comprises determining that the wire connection state is a left type, in a case where a response is received from an AFE IC of a first preset order.

12. The method as claimed in claim 9 or 10, wherein the operation (b) comprises determining that the wire connection state is a right type, in a case where a response is received from an AFE IC of a second preset order.

13. The method as claimed in any one of the claims 9 to 12, wherein the operation (c) comprises checking the wire connection state up to a final module BMS, determining that no misconnection is present in a case where all of the module BMSs are determined to have an identical wire connection state, and, in a case where a module BMS having a wire connection state different from a wire connection state of remaining module BMSs is detected, transmitting position and misconnection detection information of the corresponding module BMS to request inspection.
